# EUROPÄISCHE PATENTSCHRIFT

(11) **EP 0 413 657 B1**
(45) Veröffentlichungstag und Bekanntmachung des Hinweises auf die Patenterteilung: **27.12.1996**
(21) Anmeldenummer: 90810574.5
(22) Anmeldetag: 27.07.1990
(51) Int. Cl.: C07F 9/53, C07F 9/6568, C08F 2/50, G03F 7/029

(54) **Mono- und Diacylphosphinoxide**
Mono- and diacyl phosphine oxides
Oxydes de mono- et diacyl phosphines

(30) Priorität: 04.08.1989 CH 2897/89
(43) Veröffentlichungstag der Anmeldung: 20.02.1991
(60) Teilanmeldung: 96107166.9
(73) Patentinhaber: Ciba SC Holding AG, 4057 Basel (CH)
(72) Erfinder: Rutsch, Werner, Dr., CH-1700 Fribourg (CH); Dietliker, Kurt, Dr., CH-1700 Fribourg (CH); Hall, Roger Graham, Dr., CH-4147 Aesch (CH)

(56) Entgegenhaltungen:
- EP-A- 0 007 508
- EP-A- 0 057 474
- EP-A- 0 073 413
- EP-A- 0 184 095
- DE-A- 3 245 297
- DIE MAKROMOLEKULARE CHEMIE, Band 186, Nr. 9, September 1985, Seiten 1811-1823, Hüthig & Wepf Verlag Basel, CH; T. SUMIYOSHI et al.: "On the reactivity of phosphonyl radicals towards olefinic compounds"
- CHEMICAL ABSTRACTS, Band 70, 1969, Seite 295, abstract Nr. 11752t, Columbus, Ohio, US; A.I. RAZUMOV et al.: "Reactivity of organophosphorus carbonyl-containing compounds. III. Synthesis, properties, and structure of ethyl- and aryl(benzoyl)phosphinic acid esters", & TR. KAZAN. KHIM.-TEKHNOL. INST. 1967, No. 36, 491-7

## Beschreibung

Die Erfindung betrifft spezielle Mono- und Diacylphosphinoxide sowie deren Verwendung als Photoinitiatoren für die Photopolymerisation von ethylenisch ungesättigten Verbindungen.

Monoacylphosphinoxide sind als Photoinitiatoren bekannt aus der EP-A-7508. Bisacylphosphinoxide und ihre Verwendung als Photoinitiatoren sind bekannt aus der EP-A-184 095. Es wurden nunmehr neue Mono- und Bisacylphosphinoxide gefunden, die sich von den bekannten Verbindungen durch das Vorhandensein bestimmter Substituenten unterscheiden. Es handelt sich dabei um Verbindungen der Formel I, 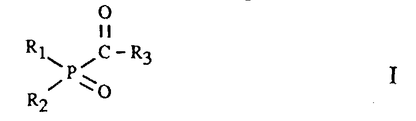
worin R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl oder einen Rest der Formel 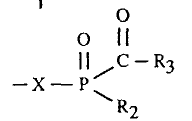 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅-Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, oder einen Rest -CO-R₃ oder -OR₄ bedeutet,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl bedeutet, und
R₄ C₁-C₁₈-Alkyl, Phenyl-C₁-C₄-alkyl, C₅-C₈-Cycloalkyl oder C₆-C₁₀-Aryl bedeutet, mit der Bestimmung, dass mindestens einer der Reste R₁, R₂ und R₃ ein substituierter Alkylrest ist.

R₁, R₂, R₃ und R₄ als C₁-C₁₈-Alkyl können verzweigtes oder unverzweigtes Alkyl sein und können z.B. Methyl, Ethyl, Propyl, Isopropyl, n-Butyl, sec-Butyl, tert-Butyl, Pentyl, Hexyl, Heptyl, Octyl, 2-Ethylhexyl, 2,4,4-Trimethylpentyl, Decyl, Dodecyl, Tetradecyl, Heptadecyl oder Octadecyl sein.

R₃ als Alkyl ist vorzugsweise tertiäres Alkyl, wie z.B. tert.Butyl, 1,1-Dimethylpropyl, 1,1-Dimethylbutyl oder 1,1,3,3-Tetramethylbutyl.

R₁ und R₂ als C₂-C₁₈-Alkenyl können z.B. Vinyl, Allyl, Methallyl, 1,1-Dimethylallyl, 2-Butenyl, 2-Hexenyl, Octenyl, Undecenyl, Dodecenyl oder Octadecenyl sein. R₄ als C₂-C₁₈-Alkenyl kann darüberhinaus auch Vinyl sein.
R₃ als C₂-C₆-Alkenyl kann z.B. Vinyl, Propenyl oder Butenyl sein.

R₁ und R₂ als ein- oder mehrfach, z.B. ein- bis 3-fach, insbesondere ein- oder zweifach, substituiertes C₁-C₈-Alkyl kann z.B. Benzyl, 1-Phenylethyl, 2-Phenylethyl, α,α-Dimethylbenzyl, Benzhydryl, p-Tolylmethyl, 1-(p-Butylphenyl)-ethyl, p-Chlorbenzyl, 2,4-Dichlorbenzyl, p-Methoxybenzyl, m-Ethoxybenzyl, 2-Cyanoethyl, 2-Cyanopropyl, 2-Methoxycarbonylethyl, 2-Ethoxycarbonylethyl, 2-Butoxycarbonylpropyl, 1,2-Di(methoxycarbonyl)-ethyl, 2-Methoxyethyl, 2-Ethoxyethyl, 2-Butoxyethyl, Diethoxymethyl, Diethoxyethyl, 1,3-Dioxolan-2-yl, 1,3-Dioxan-2-yl, 2-Methyl-1,3-dioxolan-2-yl, 4-Methyl-1,3-dioxolan-2-yl, 2-Isopropoxyethyl, 2-Butoxypropyl, 2-Octyloxyethyl, Chlormethyl, 2-Chlorethyl, Trichlormethyl oder Trifluormethyl, bevorzugt Benzyl sein.

R₃ als ein- oder mehrfach, z.B. ein- bis 3-fach, insbesondere ein- oder zweifach, substituiertes C₁-C₈-Alkyl kann z.B. Benzyl, Phenylethyl, α,α-Dimethylbenzyl, Benzhydryl, 1,1-Dichlorethyl, Trichlormethyl, Trifluormethyl, 1,1-Dimethyl-2-chlorethyl, 2-Methoxyisopropyl, 2-Ethoxyethyl, Butylthiomethyl, 2-Dodecylthioethyl oder 2-Phenylthioethyl sein.

R₄ als ein- oder mehrfach, z.B. ein- bis 3-fach, insbesondere ein- oder zweifach, substituiertes C₁-C₈-Alkyl kann z.B. Benzyl, 2-Phenylethyl, 3-Phenylpropyl, 2-Methoxyethyl, 2-Butoxyethyl, 2-Hexyloxyethyl, 2-Isopropoxypropyl, 2-Chlorethyl oder 2,2,2-Trifluorethyl sein.

R₁, R₂ und R₄ als C₅-C₈-Cycloalkyl können z.B. Cyclopentyl, Cyclohexyl oder Cyclooctyl sein.

R₁, R₂, R₃ und R₄ als C₆-C₁₂-Aryl können z.B. Phenyl, α-Naphthyl, β-Naphthyl oder 4-Diphenylyl, insbesondere Phenyl, sein. R₁, R₂ und R₃ als substituiertes C₆-C₁₂-Aryl können z.B. Chlorphenyl, Dichlorphenyl, Trichlorphenyl, Difluorphenyl, Tolyl, Ethylphenyl, tert.Butylphenyl, Dodecylphenyl, Methoxyphenyl, Dimethoxyphenyl, Ethoxyphenyl, Hexyloxyphenyl, Methylnaphthyl, Isopropylnaphthyl, Chlornaphthyl oder Ethoxynaphthyl sein. R₃ als substituiertes Aryl kann darüber hinaus auch z.B. Methoxyethylphenyl, Ethoxymethylphenyl, Methylthiophenyl, Isopropylthiophenyl oder tert.Butylthiophenyl sein. Auch substituiertes Aryl ist vorzugsweise substituiertes Phenyl.

X als C₁-C₆-Alkylen kann z.B. Methylen, 1,2-Ethylen, 2,2-Dimethyl-1,3-propylen, Tri-, Tetra-, Penta- und Hexamethylen oder Phenylmethylen sein.

Bevorzugt sind Verbindungen der Formel I, worin
R₁ C₁-C₁₂-Alkyl, durch Phenyl, (C₁-C₄-Alkyl)-phenyl, Chlorphenyl, (C₁-C₄-Alkoxy)-phenyl oder/und C₁-C₄-Alkoxy ein- bis dreifach substituiertes C₁-C₄-Alkyl, Cyclohexyl, C₆-C₁₀-Aryl oder durch Chlor, C₁-C₁₂-Alkyl oder/und C₁-C₄-Alkoxy ein- bis dreifach substituiertes C₆-C₁₀-Aryl bedeutet,
R₂ eine der für R₁ gegebenen Bedeutungen hat oder ein Rest -CO-R₃ oder -OR₄ ist,
R₃ C₁-C₈-Alkyl, mit Phenyl, C₁-C₄-Alkoxy, C₂-C₅-Alkoxycarbonyl oder/und Chlor ein- oder zweifach substituiertes C₁-C₆-Alkyl, C₆-C₁₀-Aryl oder durch C₁-C₁₂-Alkyl, C₁-C₄-Alkoxy oder/und Chlor ein- bis dreifach substituiertes C₆-C₁₀-Aryl bedeutet und R₄ C₁-C₈-Alkyl, Cyclohexyl, Benzyl oder Phenyl ist,
insbesondere worin R₁ C₁-C₈-Alkyl, durch Phenyl, (C₁-C₄-Alkyl)-phenyl oder C₁-C₄-Alkoxy ein- oder zweifach substituiertes C₁-C₄-Alkyl, Cyclohexyl, Phenyl oder durch C₁-C₄-Alkyl oder C₁-C₄-Alkoxy ein- bis dreifach substituiertes Phenyl bedeutet,
R₂ eine der für R₁ gegebenen Bedeutungen hat oder ein Rest -CO-R₃ oder -OR₄ ist,
R₃ unsubstituiertes oder durch Phenyl, Chlor oder/und C₁-C₄-Alkoxy substituiertes C₁-C₆-Alkyl, Phenyl oder durch C₁-C₄-Alkyl, C₁-C₄-Alkoxy oder/und Chlor ein- bis dreifach substituiertes Phenyl bedeutet und
R₄ C₁-C₄-Alkyl, Cyclohexyl oder Phenyl bedeutet.

Bevorzugt ist R₁ ein wie oben definierter substituierter Alkylrest, insbesondere durch Phenyl, (C₁-C₄-Alkyl)-phenyl, oder C₁-C₄-Alkoxy ein- bis zweifach substituiertes C₁-C₄-Alkyl, besonders bevorzugt ist Benzyl.

R₃ ist insbesondere ein Phenylrest, der in beiden Orthostellungen durch C₁-C₄-Alkyl, C₁-C₄-Alkoxy oder Chlor substituiert ist.

Beispiele für einzelne Verbindungen der Formel I sind:
Dibenzyl-(2,4,6-trimethylbenzoyl)-phosphinoxid
Bis(2-phenylethyl)-(2,6-dichlorbenzoyl)-phosphinoxid
Bis(2-phenylpropyl)-(2,6-dimethoxybenzoyl)-phosphinoxid
Bis(2-phenylpropyl)-(2,4,6-trimethylbenzoyl)-phosphinoxid
Bis(2-cyanoethyl)-(2,4,6-trimethylbenzoyl)-phosphinoxid
2-Phenylpropyl-(2,4,6-trimethylbenzoyl)-phosphinsäuremethylester
Phenyl-(2,2-dimethyl-3-phenylpropionyl)-phosphinsäuremethylester
Diphenyl-(2,2-dimethyl-3-phenylpropionyl)-phosphinoxid
Dibutyl-(2-methyl-2-phenylbutyryl)-phosphinoxid
Butyl-1,1-diethoxyethyl-2,4,6-trimethylbenzoyl-phosphinoxid
Bis(cyclohexyl)-(2-methyl-2-phenylthiopropionyl)-phosphinoxid
Diphenyl-(2-octyloxy-2-phenylpropionyl)-phosphinoxid
1-(2,6-Dimethylbenzoyl)-phospholan-1-oxid
Bis(2,6-dichlorbenzoyl)-2-phenylpropylphosphinoxid
Bis(2,6-dimethoxybenzoyl)-benzylphosphinoxid
Bis(2,6-dimethoxybenzoyl)-2-phenylpropylphosphinoxid
Bis(2,6-dimethoxybenzoyl)-2-phenylethylphosphinoxid
Bis(2,6-dichlorbenzoyl)-benzylphosphinoxid
Bis(2,6-dichlorbenzoyl)-2-phenylethlphosphinoxid
Bis(2,4,6-trimethylbenzoyl)-benzylphosphinoxid
Bis(2,4,6-trimethylbenzoyl)-2-phenylpropylphosphinoxid
Bis(2,4,6-trimethylbenzoyl)-2-phenylethylphosphinoxid
Bis(2,4,6-trimethylbenzoyl)-2-cyanoethylphosphinoxid
Bis(2,6-dichlorbenzoyl)-2-cyanoethylphosphinoxid
Bis(2,6-dimethoxybenzoyl)-2-cyanoethylphosphinoxid
Bis(2-methylthiobenzoyl)-2-phenylpropylphosphinoxid
Bis(2-methyl-1-naphthoyl)-2-phenylpropylphosphinoxid
Bis(2-methyl-2-phenylpropionyl)-cyclohexylphosphinoxid
Bis(2-methyl-2-phenylbutyryl)-phenylphosphinoxid
Bis(2,2-dimethyl-4-phenylbutyryl)-phenylphosphinoxid
Bis(2-methoxy-2-phenylbutyryl)-4-propylphenylphosphinoxid
Bis(2-methylthio-2-phenylbutyryl)-cyclohexylphosphinoxid
Bis(2-methyl-2-phenylthiopropionyl)-2-phenylpropylphosphinoxid
Bis(2-methyl-2-phenylbutyryl)-2-phenylpropylphosphinoxid
Bis(2-methyl-2-phenylbutyryl)-2-cyclohexylphosphinoxid
2,4,6-Trimethylbenzoyl-benzyl-butylphosphinoxid
2,6-Dichlorbenzoyl-benzyl-butylphosphinoxid
2,6-Dimethoxybenzoyl-benzyl-butylphosphinoxid
2,6-Dimethoxybenzoyl-benzyl-octylphosphinoxid
2,6-Dichlorbenzoyl-benzyl-octylphosphinoxid
2,4,6-Trimethylbenzoyl-benzyl-octylphosphinoxid
2,4,6-Trimethylbenzoyl-benzyl-methylphosphinoxid
2,4,6-Trimethylbenzoyl-benzyl-cyclohexylphosphinoxid
2,6-Dichlorbenzoyl-benzyl-cyclohexylphosphinoxid
2,6-Dimethoxybenzoyl-benzyl-cyclohexylphosphinoxid

Die Verbindungen der Formel I, worin R₂ ein Rest -OR₄ ist, können hergestellt werden durch eine Arbusow-Michaelis-Reaktion des entsprechenden Phosphonites IV mit einem Carbonsäurechlorid V nach dem Schema:

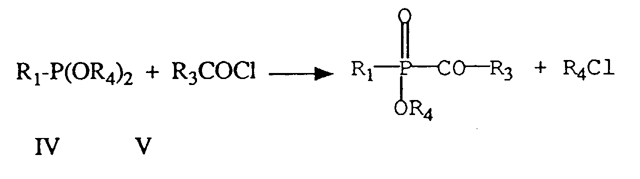

Die Umsetzung kann mit oder ohne Lösungsmittel erfolgen. Sofern die Komponenten IV und V flüssig sind, arbeitet man vorzugsweise ohne Lösungsmittel. Geeignete Lösungsmittel sind vor allem Kohlenwasserstoffe wie Alkane und Alkangemische, Benzol, Toluol oder Xylol. Die Reaktion wird vorzugsweise bei 20-120°C ausgeführt. Das entstehende R₄Cl wird vorzugsweise während der Reaktion laufend abdestilliert. Falls ein Lösungsmittel verwendet wird, wird dieses am Ende der Reaktion abdestilliert. Das rohe Reaktionsprodukt kann z.B. durch Destillation, Kristallisation oder Chromatographie gereinigt werden.

Die Phosphonite IV können in bekannter Weise durch Umsetzung eines Dichlorphosphines R₁-PCl₂ mit mindestens 2 Mol R₄OH in Gegenwart eines HCl-Akzeptors hergestellt werden (siehe dazu Houben-Weyl, Methoden d. Org. Chemie XII/1, 324-327 (1963), G. Thieme-Verlag, Stuttgart).

Die Verbindungen der Formel I, worin R₂ ein Rest -COR₃ ist, können hergestellt werden durch doppelte Acylierung eines primären Phosphins VI mit mindestens 2 Aequivalenten eines Säurechlorides V in Gegenwart von mindestens 2 Aequivalenten einer Base und anschliessende Oxydation des erhaltenen Diacylphosphins VII zum Phosphinoxid nach dem Schema:

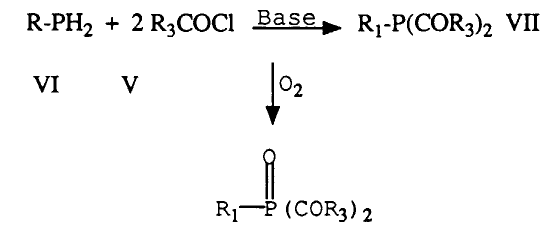

Als Base eignen sich z.B. tertiäre Amine, Alkalimetalle, Lithiumdiisopropylamid, Alkalialkoholate oder Alkalihydride. Die erste Reaktionsstufe geschieht vorzugsweise in Lösung. Als Lösungsmittel sind vor allem Kohlenwasserstoffe geeignet, wie z.B. Alkane, Benzol, Toluol oder Xylol. Nach Abtrennen des gebildeten Basenchlorides kann das Phosphin VII durch Eindampfen isoliert werden oder man führt die zweite Reaktionsstufe ohne Isolierung von VII mit der Lösung des Rohproduktes durch. Als Oxidationsmittel für die zweite Stufe eignen sich vor allem Wasserstoffperoxid und organische Peroxyverbindungen, beispielsweise Peressigsäure.

Die als Ausgangsmaterial benutzten primären Phosphine VI sind bekannte Verbindungen oder können in Analogie zu bekannten Verbindungen hergestellt werden (siehe dazu Houben-Weyl, Methoden der Org. Chemie XII/1, 60-63 (1963), G. Thieme-Verlag, Stuttgart).

Die Verbindungen der Formel I, worin R₂ weder ein Rest -OR₄ noch ein Rest -COR₃ ist, können hergestellt werden durch Acylierung von sekundären Phosphinen VIII und anschliessende Oxidation nach dem Schema:

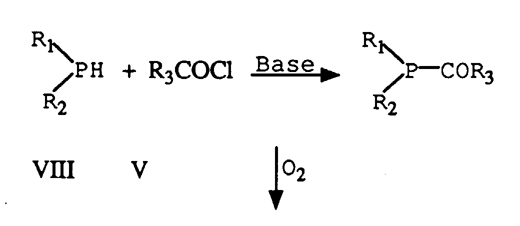

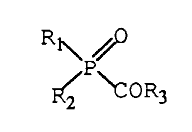

Für diese Reaktionen gilt dasselbe wie oben gesagt. Die Ausgangsphosphine VIII können nach bekannten Methoden erhalten werden, beispielsweise durch Reduktion von Monochlorphosphinen (R₁)(R₂)PCl mittels LiAlH₄ (siehe dazu Houben-Weyl, Methoden der Org. Chemie XII/1, 60-63 (1963), G. Thieme-Verlag, Stuttgart).

Eine alternative Herstellungsmöglichkeit ist die Arbusow-Michaelis-Reaktion von Phosphiniten IX mit V nach dem Schema:

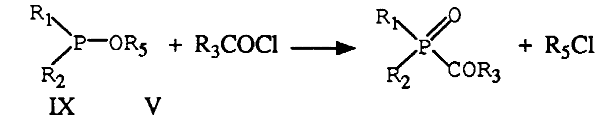

Hierin bedeutet R₅ einen Alkylrest.

Die Ausgangsmaterialien IX können nach bekannten Methoden hergestellt werden, beispielsweise durch Alkoholyse von Monochlorphosphinen (R₁)(R₂)PCl mit R₅OH in Gegenwart von Basen (siehe dazu Houben-Weyl, Methoden der Org. Chemie XII/1, 208-210 (1963), G. Thieme-Verlag, Stuttgart).

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden. Die ungesättigten Verbindungen können eine oder mehrere olefinische Doppelbindungen enthalten. Sie können niedermolekular (monomer) oder höhermolekular (oligomer) sein. Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Weiter Beispiele hierfür sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol- oder Bisphenol-A-diacrylat, 4,4′-Bis(2-acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanurat oder Tris-(2-acryloylethyl)isocyanurat.

Beispiele für höhermolekulare (oligomere) mehrfach ungesättigte Verbindungen sind acrylierte Epoxidharze, acrylierte Polyether, acrylierte Polyurethane oder acrylierte Polyester. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Solche ungesättigte Oligomere kann man auch als Prepolymere bezeichnen.

Häufig verwendet man Zweikomponeneten-Gemische eines Prepolymeren mit einem mehrfach ungesättigten Monomeren oder Dreikomponentengemische, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwendet muss.

Solche Zwei- und Dreikomponentensysteme auf der Basis eines Prepolymeren werden sowohl für Druckfarben als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensystem verwendet, wie z.B. Polymaleinimide, Polychalkone oder Polyimide, wie sie in der DE-OS 2 308 830 beschrieben sind.

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die photopolymerisierbaren Gemische können ausser dem Photoinitiator verschiedene Additive enthalten. Beispiele hierfür sind thermische Inhibitoren, die eine vorzeitige Polymerisation verhindern sollen, wie z.B. Hydrochinon oder sterisch gehinderte Phenole. Zur Erhöhung der Dunkellagerstabilität können z.B. Kupferverbindungen, Phosphorverbindungen, quartäre Ammoniumverbindungen oder Hydroxylaminderivate verwendet werden. Zwecks Ausschluss des Luftsauerstoffes während der Polymerisation kann man Paraffin oder ähnliche wachsartige Stoffe zusetzen, die bei Beginn der Polymerisation an die Oberfläche wandern. Als Lichtschutzmittel können in geringer Menge UV-Absorber, wie z.B. solche vom Benztriazol-, Benzophenon- oder Oxalanilid-Typ, zugesetzt werden. Noch besser ist der Zusatz von Lichtschutzmitteln, die UV-Licht nicht absorbieren, wie z.B. von sterisch gehinderten Aminen (HALS).

In bestimmten Fällen kann es von Vorteil sein, Gemische von zwei oder mehr der erfindungsgemässen Photoinitiatoren zu verwenden. Selbstverständlich können auch Gemische mit bekannten Photoinitiatoren verwendet werden, z.B. Gemische mit Benzophenon, Acetophenonderivaten, Benzoinethern oder Benzilketalen.

Zur Beschleunigung der Photopolymerisation können Amine zugesetzt werden, wie z.B. Triethanolamin, N-Methyl-diethanolamin, p-Dimethylaminobenzoesäure-ethylester oder Michlers Keton. Die Wirkung der Amine kann verstärkt werden durch den Zusatz von aromatischen Ketonen vom Typ des Benzophenons.

Eine Beschleunigung der Photopolymerisation kann weiterhin durch Zusatz von Photosensibilisatoren geschehen, welche die spektrale Empfindlichkeit verschieben bzw. verbreitern. Dies sind insbesondere aromatische Carbonylverbindungen wie z.B. Benzophenon-, Thioxanthon-, Anthrachinon- und 3-Acylcumarinderivate sowie 3-(Aroylmethylen)-thiazoline.

Weitere übliche Zusätze sind - je nach Verwendungszweck - Füllstoffe, Pigmente, Farbstoffe, Netzmittel oder Verlaufhilfsmittel.

Die Erfindung betrifft daher auch photopolymerisierbare Zusammensetzungen, enthaltend
a) mindestens eine ethylenisch ungesättigte photopolymerisierbare Verbindung und
b) als Photoinitiator mindestens eine Verbindung der Formel I,
wobei die Zusammensetzung ausserdem noch einen anderen Photoinitiator und/oder andere Additive enthalten kann.

Die photopolymerisierbaren Zusammensetzungen enthalten den Photoinitiator (b) zweckmässig in einer Menge von 0,05 bis 15 Gew.-%, vorzugsweise 0,2 bis 5 Gew.-%, bezogen auf die Zusammensetzung.

Die photopolymerisierbaren Zusammensetzungen können für verschiedene Zwecke verwendet werden, beispielsweise als Druckfarbe, als Weisslack, als Anstrichstoff, als Anstrichstoff für Aussenanstriche, für photographische Reproduktionsverfahren, für Bildaufzeichnungsverfahren oder zur Herstellung von Druckplatten, als Zahnfüllmassen, als Klebstoffe, als Ueberzüge von optischen Fasern, für gedruckte Schaltungen oder zur Beschichtung von elektronischen Teilen.

Die Polymerisation erfolgt nach den bekannten Methoden der Photopolymerisation durch Bestrahlung mit Sonnenlicht oder mit Licht, das reich an kurzwelliger Strahlung ist. Als Lichtquellen sind z.B. Quecksilbermitteldruck-, -hochdruck- und -niederdruckstrahler, superaktinische Leuchstoffröhren, Metallhalogenid-Lampen oder Laser geeignet, deren Emissionsmaxima im Bereich zwischen 250 und 450 nm liegen. Im Falle einer Kombination mit Photosensibilisatoren können auch längerwelliges Licht oder Laserstrahlen bis 600 nm verwendet werden.

Die nachfolgenden Beispiele erläutern die Erfindung weiter. Angaben in Teilen oder Prozenten beziehen sich, ebenso wie in der übrigen Beschreibung und in den Patentansprüchen, auf das Gewicht, sofern nichts anderes angegeben ist.

### Beispiel 1 Herstellung von Bis(2-phenylpropyl)-(2,6-dimethoxybenzoyl)-phosphinoxid

Zu einer Lösung aus 1,1 g (0,011 Mol) Diisopropylamin in 10 ml absolutem Tetrahydrofuran (THF) werden unter Argon bei 0°C 6,9 ml (0,011 Mol, 1,6 M) Butyllithium innerhalb 10 Minuten zugetropft.
Diese Lösung wird bei -20 bis -30°C innerhalb ca. 40 Minuten zu einer Lösung aus 2,2 g (0,011 Mol) 2,6-Dimethoxybenzoylchlorid und 2,7 g (0,01 Mol) Bis(2-phenylpropyl)-phosphin in 20 ml absolutem THF getropft.
Nach 2 h rühren bei -30°C lässt man die gelbe Lösung auf Raumtemperatur erwärmen, verdünnt mit 100 ml Toluol und wäscht einmal mit Wasser und einmal mit gesättigter Natriumbicarbonatlösung. Die organische Phase wird mit Magnesiumsulfat getrocknet, filtriert und am Rotationsverdampfer eingeengt. Der Rückstand wird in 40 ml Acetonitril gelöst und mit 1,1 g (0,01 Mol) 30 %-igem Wasserstoffperoxid versetzt.
Nach 1 h rühren bei 50°C wird mit Toluol verdünnt, mit Sole und gesättigter Natriumcarbonatlösung nachgewaschen, mit Magnesiumsulfat getrocknet und am Rotationsverdampfer eingedampft. Nach Reinigung mittels Chromatographie (Laufmittel: Hexan/Essigester 1:1) erhält man 3,1 g, das sind 68,9 % der Theorie der oben genannten Titelverbindung als gelbes Oel.

| Elementaranalyse | | |
|---|---|---|
| ber. | C 71,98 % | H 6,94 % |
| gef. | C 71,45 % | H 7,05 % |

### Beispiel 2 Herstellung von Bis(2-phenylpropyl)-(2,4,6-trimethylbenzoyl)-phosphinoxid.

Das oben genannte Phosphinoxid wird analog zu der in Beispiel 1 beschriebenen Methode hergestellt:

| Elementaranalyse | | |
|---|---|---|
| ber. | C 77,75 % | H 7,69 % |
| gef. | C 77,24 % | H 7,72 % |

### Beispiel 3 Herstellung von Diphenyl-[2,2-bis(chlormethyl)propionyl]-phosphinoxid

3,8 g (0,02 Mol) Dichlorpivaloylchlorid werden in 20 ml Toluol vorgelegt und auf 80°C erwärmt. Innerhalb von ca. 5 Minuten werden zu dieser Lösung 4,3 g (0,02 Mol) Methoxydiphenylphosphin zugetropft, wobei Methylchlorid entweicht. Nach 1 h rühren bei 80°C wird die leicht gelbe Lösung auf Raumtemperatur abgekühlt und am Rotationsverdampfer eingedampft. Nach Reinigung durch Chromatographie (Laufmittel: Hexan/Essigester 3:1) erhält man 1,6 g, das sind 22,8 % der Theorie, der oben genannten Verbindung als gelbes Harz.

| Elementaranalyse | | | |
|---|---|---|---|
| ber. | C 57,48 % | H 4,82 % | Cl 19,96 % |
| gef. | C 57,37 % | H 5,16 % | Cl 18,84 % |

### Beispiel 4 Herstellung von Ethoxy-(2,6-dimethoxybenzoyl)-(diethoxymethyl)-phosphinoxid

Die Herstellung erfolgt analog zu der in Beispiel 3 beschriebenen Methode.
Man erhält die Verbindung mit einem Schmelzpunkt von 81°C.

| Elementaranalyse | | | |
|---|---|---|---|
| ber. | C 53,33 % | H 6,99 % | P 8,60 % |
| gef. | C 53,15 % | H 6,94 % | P 9,24 % |

### Beispiel 5 Initiator-Reaktivität in einer Weisslack-Dickschicht

Ein Weisslack wird hergestellt aus
- 30 Teilen: ®Ebecryl 608 (Epoxyacrylat der Fa. UCB, Belgien)
- 15 Teilen: Trimethylolpropan-trisacrylat
- 5 Teilen: N-Vinylpyrrolidon
- 50 Teilen: Titandioxid (Rutil).

In den Weisslack werden zwei Gewichtsprozent des zu prüfenden Photoinitiators eingearbeitet und die Formulierung wird in einer Schichtdicke von 100 µm auf Aluminiumbleche, die mit einem weissen Coil-Coat-Lack grundiert sind, aufgetragen.
Die Proben werden unter einer Hg-Mitteldrucklampe (Hanovia, 80 W/cm) durchgehärtet. Die Durchhärtung ist erfolgt, wenn die Unterseite eines abgetrennten Lackfilmes trocken ist. Zur Messung der Reaktivität wird die Anzahl der Durchläufe unter der Lampe bei einer bestimmten Bandgeschwindigkeit ermittelt. Die Reaktivität wird ausserdem nach einer Vorbelichtung von einer Minute unter 5 Lampen von 40 W (Philips TL03) gemessen. Die Pendelhärte (nach König, DIN 53157), die Vergilbung (Yellowness-Index, ASTM D1925-70) und der Glanz bei 20° und 60° (Multiglossgerät, ASTM D 523) werden direkt nach der Härtung und nach einer zusätzlichen Bestrahlung von 15 Minuten bzw. 16 h (Glanz) unter 5 Lampen von 40 W (Philips TL03) gemessen.
Die Ergebnisse sind in den Tabellen 1 und 2 wiedergegeben.

**Tabelle 1:**

| Weisslack-Dickschicht ohne Vorbelichtung | | | | | | | |
|---|---|---|---|---|---|---|---|
| Verbindung gemäss Beispiel | Wischfestigkeit* | Pendelhärte [sec] | | Yellowness Index | | Glanz (20/60°) | |
| | | sofort | nach 15 Min. | sofort | nach 15 Min. | sofort | nach 16 h |
| 2 | 6 | 43 | 70 | 1,2 | 0,8 | 78/90 | 77/90 |
| 1 | 7 | 36 | 90 | 1,1 | 0,8 | 81/91 | 79/92 |

| | | | | | | | |
|---|---|---|---|---|---|---|---|
| * als Anzahl der Durchläufe bei 20 m/min. | | | | | | | |

**Tabelle 2:**

| Weisslack-Dickschicht mit Vorbelichtung | | | | | | | |
|---|---|---|---|---|---|---|---|
| Verbindung gemäss Beispiel | Wischfestigkeit* | Pendelhärte [sec] | | Yellowness Index | | Glanz (20/60°) | |
| | | sofort | nach 15 Min. | sofort | nach 15 Min. | sofort | nach 16 h |
| 1 | 7 | 35 | 76 | 1,6 | 1,2 | 81/91 | 80/91 |
| 2 | 8 | 38 | 56 | 1,8 | 1,4 | 59/89 | 58/89 |

| | | | | | | | |
|---|---|---|---|---|---|---|---|
| * als Anzahl der Durchläufe bei 20 m/min. | | | | | | | |

### Beispiel 6 Initiator-Reaktivität in einem Klarlack

Ein Klarlack wird bereitet aus
- 99, 5 Teilen: ®Roskydal UV 502 A (Lösung eines ungesättigten Polyesters in Styrol, Fa. BAYER, BRD)
- 0,5 Teilen: ®Byk 300 (Additiv).

Es werden zwei Gewichtsprozent des zu prüfenden Photoinitiators zugemischt und die Formulierung wird in einer Schichtdicke von 100 µm auf Spanplatten, die mit weissem Kunstharz beschichtet sind, aufgetragen.
Die Proben werden in einem PPG-Bestrahlungsgerät mit Hg-Mitteldrucklampen (2x80 W/cm) bestrahlt. Dabei wird die Bandgeschwindigkeit in m/min ermittelt, die zur Erreichung einer wischfesten Lackoberfläche nötig ist. Die Härte wird durch die Messung der Pendelhärte nach König (DIN 53157) bestimmt und die Vergilbung wird als Yellowness-Index (ASTM D 1925-70) gemessen.
Die Ergebnisse sind in Tabelle 3 wiedergegeben.

**Tabelle 3:**

| Verbindung gemäss Beispiel | Wischfestigkeit [Anzahl der Durchläufe bei 20 m/min] | Pendelhärte [sec] | Yellowness Index |
|---|---|---|---|
| 3 | 5 | 82 | 6,6 |

## Patentansprüche (Patentansprüche für folgende(n) Vertragsstaat(en): BE, CH, DE, FR, GB, IT, LI, NL)

1. Eine Verbindung der Formel I, 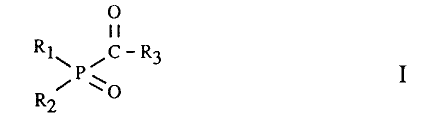 worin
R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, oder einen Rest der Formel 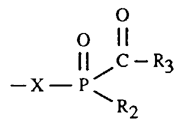 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅-Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, oder einen Rest -CO-R₃ oder -OR₄ bedeutet,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl bedeutet, und
R₄ C₁-C₁₈-Alkyl, Phenyl-C₁-C₄-alkyl, C₅-C₈-Cycloalkyl oder C₆-C₁₀-Aryl bedeutet, mit der Bestimmung, dass mindestens einer der Reste R₁, R₂ und R₃ ein substituierter Alkylrest ist.

2. Eine Verbindung gemäss Anspruch 1 der Formel I, worin
R₁ C₁-C₁₂-Alkyl, durch Phenyl, (C₁-C₄-Alkyl)-phenyl, Chlorphenyl, (C₁-C₄-Alkoxy)-phenyl oder/und C₁-C₄-Alkoxy ein- bis dreifach substituiertes C₁-C₄-Alkyl, Cyclohexyl, C₆-C₁₀-Aryl oder durch Chlor, C₁-C₁₂-Alkyl oder/und C₁-C₄-Alkoxy ein- bis dreifach substituiertes C₆-C₁₀-Aryl bedeutet,
R₂ eine der für R₁ gegebenen Bedeutungen hat oder ein Rest -CO-R₃ oder -OR₄ ist,
R₃ C₁-C₈-Alkyl, mit Phenyl, C₁-C₄-Alkoxy, C₂-C₅-Alkoxycarbonyl oder/und Chlor ein- oder zweifach substituiertes C₁-C₆-Alkyl, C₆-C₁₀-Aryl oder durch C₁-C₁₂-Alkyl, C₁-C₄-Alkoxy oder/und Chlor ein- bis dreifach substituiertes C₆-C₁₀-Aryl bedeutet und R₄ C₁-C₈-Alkyl, Cyclohexyl, Benzyl oder Phenyl ist.

3. Eine Verbindung gemäss Anspruch 1 der Formel I, worin
R₁ C₁-C₈-Alkyl, durch Phenyl, (C₁-C₄-Alkyl)-phenyl oder C₁-C₄-Alkoxy ein- oder zweifach substituiertes C₁-C₄-Alkyl, Cyclohexyl, Phenyl oder durch C₁-C₄-Alkyl oder C₁-C₄-Alkoxy ein- bis dreifach substituiertes Phenyl bedeutet,
R₂ eine der für R₁ gegebenen Bedeutungen hat oder ein Rest -CO-R₃ oder -OR₄ ist,
R₃ unsubstituiertes oder durch Phenyl, Chlor oder/und C₁-C₄-Alkoxy substituiertes C₁-C₆-Alkyl, Phenyl oder durch C₁-C₄-Alkyl, C₁-C₄-Alkoxy oder/und Chlor ein- bis dreifach substituiertes Phenyl bedeutet und
R₄ C₁-C₄-Alkyl, Cyclohexyl oder Phenyl bedeutet.

4. Eine Verbindung gemäss Anspruch 1 der Formel I, worin R₁ ein wie in Anspruch 1 definierter substituierter Alkylrest ist.

5. Eine Verbindung gemäss Anspruch 4, worin R₁ durch Phenyl, (C₁-C₄-Alkyl)-phenyl, Chlorphenyl, C₁-C₄-Alkoxy oder Cyano substituiertes C₁-C₄-Alkyl ist.

6. Eine Verbindung gemäss Anspruch 1 der Formel I, worin R₁ Benzyl ist.

7. Eine Verbindung gemäss Anspruch 1 der Formel I, worin R₂ unsubstituiertes oder durch Phenyl, (C₁-C₄-Alkyl)-phenyl, Chlorphenyl, C₁-C₄-Alkoxy oder Cyano substituiertes C₁-C₄-Alkyl, Phenyl oder Cycloalkyl bedeutet

8. Eine Verbindung gemäss Anspruch 1 der Formel I, worin R₃ durch C₁-C₄-Alkyl, C₁-C₄-Alkoxy oder Chlor substituiertes Phenyl ist.

9. Eine Verbindung gemäss Anspruch 1 der Formel I, worin R₃ mit Phenyl, C₂-C₅-Alkoxycarbonyl, Halogen oder/und C₁-C₁₂-Alkoxy ein- bis dreifach substituiertes C₁-C₈-Alkyl ist.

10. Eine Verbindung gemäss Anspruch 1 der Formel I, worin R₂ einen Rest -CO-R₃ bedeutet.

11. Eine Verbindung gemäss Anspruch 1 der Formel I, worin
R₁ unsubstituiertes oder mit Phenyl, C₁-C₄-Alkoxy oder Chlor substituiertes C₁-C₄-Alkyl, Phenyl, (C₁-C₄-Alkyl)-phenyl ist, R₂ die Bedeutung von R₁ hat oder -O-(C₁-C₄-Alkyl) ist und R₃ für unsubstituiertes oder durch C₁-C₄-Alkyl, C₁-C₄-Alkoxy oder/und Chlor substituiertes Phenyl, unsubstituiertes oder durch Chlor, C₁-C₄-Alkoxy oder Phenyl substituiertes C₁-C₄-Alkyl steht.

12. Eine Verbindung gemäss Anspruch 1 der Formel I, worin
R₁ mit Phenyl oder C₁-C₄-Alkoxy substituiertes C₁-C₄-Alkyl oder Phenyl bedeutet, R₂ die Bedeutung von R₁ hat oder für -O-(C₁-C₄-Alkyl) steht und R₃ durch C₁-C₄-Alkyl oder C₁-C₄-Alkoxy substituiertes Phenyl, durch Chlor substituiertes C₁-C₄-Alkyl ist.

13. Photopolymerisierbare Zusammensetzung, enthaltend
a) mindestens eine ethylenisch ungesättigte photopolymerisierbare Verbindung und
b) als Photoinitiator mindestens eine Verbindung der Formel I wie in Anspruch 1 definiert.

14. Zusammensetzung gemäss Anspruch 13, dadurch gekennzeichnet, dass sie neben dem Photoinitiator (b) noch einen anderen Photoinitiator und/oder andere Additive enthält.

15. Zusammensetzung gemäss Anspruch 13, enthaltend
0,05 bis 15 Gew.-% der Komponente (b), bezogen auf die Zusammensetzung.

16. Zusammensetzung gemäss Anspruch 13, enthaltend
0,2 bis 5 Gew.-% der Komponente (b), bezogen auf die Zusammensetzung.

17. Verwendung von in Anspruch 1 definierten Verbindungen als Photoinitiatoren für die Photopolymerisation ethylenisch ungesättigter Verbindungen.

18. Verwendung gemäss Anspruch 17 in Kombination mit einem anderen Photoinitiator und/oder anderen Additiven.

19. Zusammensetzung gemäss Anspruch 13, die mindestens einen weiteren Photoinitiator enthält.

20. Verfahren zur Photopolymerisation von nichtflüchtigen monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I nach Anspruch 1 zugibt und mit Licht im Bereich von 200 bis 600 nm bestrahlt.

## Patentansprüche (Patentansprüche für folgende(n) Vertragsstaat(en): ES)

1. Photopolymerisierbare Zusammensetzung, enthaltend
a) mindestens eine ethylenisch ungesättigte photopolymerisierbare Verbindung und
b) als Photoinitiator mindestens eine Verbindung der Formel I 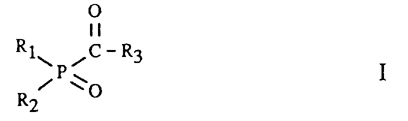 worin
R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, oder einen Rest der Formel 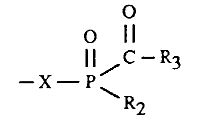 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅-Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, oder einen Rest -CO-R₃ oder -OR₄ bedeutet,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl bedeutet und
R₄ C₁-C₁₈-Alkyl, Phenyl-C₁-C₄-alkyl, C₅-C₈-Cycloalkyl oder C₆-C₁₀-Aryl bedeutet, mit der Bestimmung, dass mindestens einer der Reste R₁, R₂ und R₃ ein substituierter Alkylrest ist.

2. Zusammensetzung nach Anspruch 1, worin
R₁ C₁-C₁₂-Alkyl, durch Phenyl, (C₁-C₄-Alkyl)-phenyl, Chlorphenyl, (C₁-C₄-Alkoxy)-phenyl oder/und C₁-C₄-Alkoxy ein- bis dreifach substituiertes C₁-C₄-Alkyl, Cyclohexyl, C₆-C₁₀-Aryl oder durch Chlor, C₁-C₁₂-Alkyl oder/und C₁-C₄-Alkoxy ein- bis dreifach substituiertes C₆-C₁₀-Aryl bedeutet,
R₂ eine der für R₁ gegebenen Bedeutungen hat oder ein Rest -CO-R₃ oder -OR₄ ist,
R₃ C₁-C₈-Alkyl, mit Phenyl, C₁-C₄-Alkoxy, C₂-C₅-Alkoxycarbonyl oder/und Chlor ein- oder zweifach substituiertes C₁-C₆-Alkyl, C₆-C₁₀-Aryl oder durch C₁-C₁₂-Alkyl, C₁-C₄-Alkoxy oder/und Chlor ein- bis dreifach substituiertes C₆-C₁₀-Aryl bedeutet und R₄ C₁-C₈-Alkyl, Cyclohexyl, Benzyl oder Phenyl ist.

3. Zusammensetzung nach Anspruch 1, worin
R₁ C₁-C₈-Alkyl, durch Phenyl, (C₁-C₄-Alkyl)-phenyl oder C₁-C₄-Alkoxy ein- oder zweifach substituiertes C₁-C₄-Alkyl, Cyclohexyl, Phenyl oder durch C₁-C₄-Alkyl oder C₁-C₄-Alkoxy ein- bis dreifach substituiertes Phenyl bedeutet,
R₂ eine der für R₁ gegebenen Bedeutungen hat oder ein Rest -CO-R₃ oder -OR₄ ist
R₃ unsubstituiertes oder durch Phenyl, Chlor oder/und C₁-C₄-Alkoxy substituiertes C₁-C₆-Alkyl, Phenyl oder durch C₁-C₄-Alkyl, C₁-C₄-Alkoxy oder/und Chlor ein- bis dreifach substituiertes Phenyl bedeutet und
R₄ C₁-C₄-Alkyl, Cyclohexyl oder Phenyl bedeutet.

4. Zusammensetzung nach Anspruch 1, worin R₁ ein wie in Anspruch 1 definierter substituierter Alkylrest ist.

5. Zusammensetzung nach Anspruch 4, worin R₁ durch Phenyl, (C₁-C₄-Alkyl)-phenyl, Chlorphenyl, C₁-C₄-Alkoxy oder Cyano substituiertes C₁-C₄-Alkyl ist.

6. Zusammensetzung nach Anspruch 1 der Formel I, worin R₁ Benzyl ist.

7. Zusammensetzung nach Anspruch 1 der Formel I, worin R₂ unsubstituiertes oder durch Phenyl, (C₁-C₄-Alkyl)-phenyl, Chlorphenyl, C₁-C₄-Alkoxy oder Cyano substituiertes C₁-C₄-Alkyl, Phenyl oder Cycloalkyl bedeutet.

8. Zusammensetzung nach Anspruch 1 der Formel I, worin R₃ durch C₁-C₄-Alkyl, C₁-C₄-Alkoxy oder Chlor substituiertes Phenyl ist.

9. Zusammensetzung nach Anspruch 1 der Formel I, worin R₃ mit Phenyl, C₂-C₅-Alkoxycarbonyl, Halogen oder/und C₁-C₁₂-Alkoxy ein- bis dreifach substituiertes C₁-C₈-Alkyl ist.

10. Zusammensetzung nach Anspruch 1, worin in der Formel I R₂ einen Rest -CO-R₃ bedeutet.

11. Zusammensetzung nach Anspruch 1, worin in der Formel I
R1 unsubstituiertes oder mit Phenyl, C₁-C₄-Alkoxy oder Chlor substituiertes C₁-C₄-Alkyl, Phenyl, (C₁-C₄-Alkyl)-phenyl ist, R₂ die Bedeutung von R₁ hat oder -O-(C₁-C₄-Alkyl) ist und R₃ für unsubstituiertes oder durch C₁-C₄-Alkyl, C₁-C₄-Alkoxy oder/und Chlor substituiertes Phenyl, unsubstituiertes oder durch Chlor, C₁-C₄-Alkoxy oder Phenyl substituiertes C₁-C₄-Alkyl steht.

12. Zusammensetzung nach Anspruch 1, worin in der Formel I
R₁ mit Phenyl oder C₁-C₄-Alkoxy substituiertes C₁-C₄-Alkyl oder Phenyl bedeutet, R₂ die Bedeutung von R₁ hat oder für -O-(C₁-C₄-Alkyl) steht und R₃ durch C₁-C₄-Alkyl oder C₁-C₄-Alkoxy substituiertes Phenyl, durch Chlor substituiertes C₁-C₄-Alkyl ist.

13. Zusammensetzung gemäss Anspruch 1, dadurch gekennzeichnet, dass sie neben dem Photoinitiator (b) noch einen anderen Photoinitiator und/oder andere Additive enthält.

14. Zusammensetzung gemäss Anspruch 1, enthaltend
0,05 bis 15 Gew.-% der Komponente (b), bezogen auf die Zusammensetzung.

15. Zusammensetzung gemäss Anspruch 1, enthaltend
0,2 bis 5 Gew.-% der Komponente (b), bezogen auf die Zusammensetzung.

16. Verwendung von in Anspruch 1 definierten Verbindungen als Photoinitiatoren für die Photopolymerisation ethylenisch ungesättigter Verbindungen.

17. Verwendung gemäss Anspruch 16 in Kombination mit einem anderen Photoinitiator und/oder anderen Additiven.

18. Zusammensetzung gemäss Anspruch 1, die mindestens einen weiteren Photoinitiator enthält.

19. Verfahren zur Photopolymerisation von nichtflüchtigen monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I nach Anspruch 1 zugibt und mit Licht im Bereich von 200 bis 600 nm bestrahlt.

20. Verfahren zur Herstellung von Verbindungen der Formel I 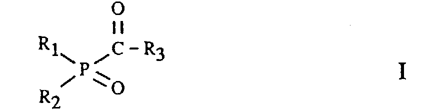 worin
R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, oder einen Rest der Formel 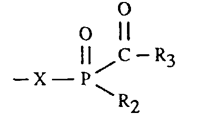 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅-Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, oder einen Rest -CO-R₃ oder -OR₄ bedeutet,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl bedeutet, und
R₄ C₁-C₁₈-Alkyl, Phenyl-C₁-C₄-alkyl, C₅-C₈-Cycloalkyl oder C₆-C₁₀-Aryl bedeutet, mit der Bestimmung, dass mindestens einer der Reste R₁, R₂ und R₃ ein substituierter Alkylrest ist oder dass R₃ ein substituierter Cycloalkylrest ist der jedoch Alkylreste nicht als alleinige Substituenten enthalten kann, dadurch gekennzeichnet, dass man primäre oder sekundäre Phosphine der Formel IIa oder IIb
R₁ - PH₂ (IIa), 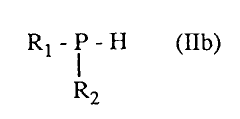
oder Phosphonite der Formel IIIa oder IIIb 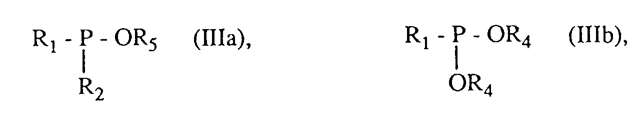 worin R₁, R₂ und R₄ die oben genannte Bedeutung haben und R₅ für ein C₁-C₂₀-Alkyl steht,
mit einem Säurechlorid der Formel IV 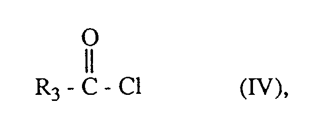 worin R₃ die oben genannte Bedeutung hat, umsetzt und, im Falle dass Verbindungen der Formel IIa oder IIb als Edukte verwendet werden, das Acylierungsprodukt anschliessend oxidiert.

21. Verfahren nach Anspruch 20, worin die Acylierung in Gegenwart einer Base durchgeführt wird.

## Claims (Claims for the following Contracting State(s): BE, CH, DE, FR, GB, IT, LI, NL)

1. A compound of the formula I 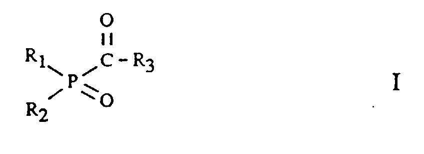 in which R₁ is C₁-C₁₈alkenyl, C₁-C₈alkyl which is monosubstituted or polysubstituted by phenyl, (C₁-C₁₂alkyl)-phenyl, halogenophenyl, (C₁-C₁₂alkoxy)-phenyl, cyano, C₂-C₅alkoxycarbonyl, C₁-C₁₂alkoxy or/and halogen, C₅-C₈cycloalkyl, C₆-C₁₂aryl which is unsubstituted or mono- or poly-substituted by halogen, C₁-C₁₂alkyl or/and C₁-C₁₂alkoxy, or is a radical of the formula 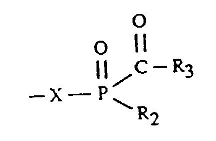 in which X is xylylene, cyclohexylene, C₁-C₆alkylene or phenylene which is unsubstituted or monosubstituted or polysubstituted by halogen, C₁-C₄alkyl, C₁-C₄alkoxy or phenyl, R₂ is C₁-C₁₈alkyl, C₂-C₁₈alkenyl, C₁-C₈alkyl which is monosubstituted or polysubstituted by phenyl, (C₁-C₁₂alkyl)-phenyl, halogenophenyl, (C₁-C₁₂alkoxy)-phenyl, cyano, C₂-C₅alkoxycarbonyl, C₁-C₁₂alkoxy or/and halogen, C₅-C₈cycloalkyl, C₆-C₁₂aryl which is unsubstituted or mono- or poly-substituted by halogen, C₁-C₁₂alkyl or/and C₁-C₁₂alkoxy, or is a radical -CO-R₃ or -OR₄, R₃ is C₁-C₁₈alkyl, C₂-C₆alkenyl, phenylvinyl, C₁-C₈alkyl which is mono- or poly-substituted by phenyl, C₂-C₅alkoxycarbonyl, halogen, C₁-C₁₂alkoxy, phenoxy, C₁-C₁₈alkylthio or/and phenylthio, C₆-C₁₂aryl which is unsubstituted or mono- or poly-substituted by C₁-C₁₂alkyl, C₁-C₁₂alkoxy, C₁-C₁₂alkoxyalkyl, C₁-C₄alkylthio or/and halogen, and R₄ is C₁-C₁₈alkyl, phenyl-C₁-C₄alkyl, C₅-C₈cycloalkyl or C₆-C₁₀aryl with the proviso that at least one of the radicals R₁, R₂ and R₃ is a substituted alkyl radical.

2. A compound according to claim 1 of the formula I, in which R₁ is C₁-C₁₈alkyl, C₁-C₄alkyl which is mono- to tri-substituted by phenyl, (C₁-C₄alkyl) -phenyl, chlorophenyl, (C₁-C₄alkoxy) -phenyl or/and C₁-C₄alkoxy, cyclohexyl, C₆-C₁₀aryl which is unsubstituted or mono- to tri-substituted by chlorine, C₁-C₁₂alkyl or/and C₁-C₄alkoxy, R₂ is as defined for R₁ or a radical -CO-R₃ or -OR₄, R₃ is C₁-C₈alkyl, C₁-C₆alkyl which is mono- or di-substituted by phenyl, C₁-C₄alkoxy, C₂-C₅alkoxycarbonyl or/and chlorine, or C₆-C₁₀aryl which is unsubstituted or mono- to tri-substituted by C₁-C₁₂alkyl, C₁-C₄alkoxy or/and chlorine, and R₄ is C₁-C₈alkyl, cyclohexyl, benzyl or phenyl.

3. A compound according to claim of the formula I, in which R₁ is C₁-C₈alkyl, C₁-C₄alkyl which is mono- or di-substituted by phenyl (C₁-C₄alkyl)-phenyl or C₁-C₄alkoxy, cyclohexyl or phenyl which is unsubstituted or mono- to tri-substituted by C₁-C₄alkyl or C₁-C₄alkoxy, R₂ is as defined for R₁ or is a radical -CO-R₃ or -OR₄, R₃ is C₁-C₆alkyl which is unsubstituted or substituted by phenyl, chlorine or/and C₁-C₄alkoxy, or phenyl which is unsubstituted or mono- to tri-substituted by C₁-C₄alkyl, C₁-C₄alkoxy or/and chlorine, and R₄ is C₁-C₄alkyl, cyclohexyl or phenyl.

4. A compound according to claim 1 of the formula I, in which R₁ is a substituted alkyl radical as defined in claim 1.

5. A compound according to claim 4, in which R₁ is C₁-C₄alkyl which is substituted by phenyl, (C₁-C₄alkyl)-phenyl, chlorophenyl, C₁-C₄alkoxy or cyano.

6. A compound according to claim of the formula I, in which R₁ is benzyl.

7. A compound according to claim 1 of the formula I, in which R₂ is C₁-C₄alkyl which is unsubstituted or substituted by phenyl, (C₁-C₄alkyl)-phenyl, chlorophenyl, C₁-C₄alkoxy or cyano, or is phenyl or cycloalkyl.

8. A compound according to claim 1 of the formula I, in which R₃ is phenyl which is substituted by C₁-C₄alkyl, C₁-C₄alkoxy or chlorine.

9. A compound according to claim 1 of the formula I, in which R₃ is C₁-C₈alkyl which is mono- to tri-substituted by phenyl, C₂-C₅alkoxycarbonyl, halogen or/and C₁-C₁₂alkoxy.

10. A compound according to claim of the formula I, in which R₂ is a radical -CO-R₃.

11. A compound according to claim of the formula I, in which R₁ is C₁-C₄alkyl which is unsubstituted or substituted by phenyl, C₁-C₄alkoxy or chlorine, phenyl or (C₁-C₄alkyl)-phenyl, R₂ is as defined for R₁ or is -O-(C₁-C₄alkyl) and R₃ is phenyl which is unsubstituted or substituted by C₁-C₄alkyl, C₁-C₄alkoxy or/and chlorine, C₁-C₄alkyl which is unsubstituted or substituted by chlorine, C₁-C₄alkoxy or phenyl.

12. A compound according to claim of the formula I, in which R₁ is C₁-C₄alkyl substituted by phenyl or C₁-C₄alkoxy, or phenyl, R₂ is as defined for R₁ or is -O-(C₁-C₄alkyl) and R₃ is phenyl substituted by C₁-C₄alkyl or C₁-C₄alkoxy, C₁-C₄alkyl substituted by chlorine.

13. A photopolymerizable composition, containing a) at least one ethylenically unsaturated photopolymerizable compound and b) at least one compound of the formula I as defined in claim 1 as a photoinitiator.

14. A composition according to claim 13, which contains, in addition to the photoinitiator (b) also another photoinitiator and/or other additives.

15. A composition according to claim 13, containing 0.05 to 15 % by weight of component (b), relative to the composition.

16. A composition according to claim 13, containing 0.2 to 5 % by weight of component (b), relative to the composition.

17. The use of compounds defined in claim 1 as photoinitiators for the photopolymerization of ethylenically unsaturated compounds.

18. The use according to claim 17 in combination with another photoinitiator and/or other additives.

19. A composition according to claim 13, which contains at least one further photoinitiator.

20. A process for photopolymerizing non-volatile monomeric, oligomeric or polymeric compounds having at least one ethylenically unsaturated double bond, which comprises adding a compound of the formula I according to claim to the said compounds and irradiating with light in the range from 200 to 600 nm.

## Claims (Claims for the following Contracting State(s): ES)

1. A photopolymerizable composition, containing
a) at least one ethylenically unsaturated photopolymerizable compound
and b) at least one compound of the formula I as a photoinitiator. 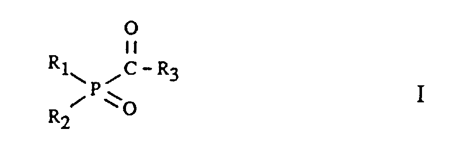 in which R₁ is C₁-C₁₈alkyl, C₂-C₁₈alkenyl, C₁-C₈alkyl which is monosubstituted or polysubstituted by phenyl, (C₁-C₁₂alkyl)-phenyl, halogenophenyl, (C₁-C₁₂alkoxy)-phenyl, cyano, C₂-C₅alkoxycarbonyl, C₁-C₁₂alkoxy or/and halogen, C₅-C₈cycloalkyl, C₆-C₁₂aryl which is unsubstituted or mono- or poly-substituted by halogen, C₁-C₁₂alkyl or/and C₁-C₁₂alkoxy, or is a radical of the formula 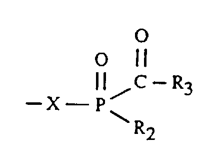 in which X is xylylene, cyclohexylene, C₁-C₆alkylene or phenylene which is unsubstituted or monosubstituted or polysubstituted by halogen, C₁-C₄alkyl, C₁-C₄alkoxy or phenyl, R₂ is C₁-C₁₈alkyl, C₂-C₁₈alkenyl, C₁-C₈alkyl which is monosubstituted or polysubstituted by phenyl, (C₁-C₁₂alkyl)-phenyl, halogenophenyl, (C₁-C₁₂alkoxy)-phenyl, cyano, C₂-C₅alkoxycarbonyl, C₁-C₁₂alkoxy or/and halogen, C₅-C₈cycloalkyl, C₆-C₁₂aryl which is unsubstituted or mono- or poly-substituted by halogen, C₁-C₁₂alkyl or/and C₁-C₁₂alkoxy, or is a radical -CO-R₃ or -OR₄, R₃ is C₁-C₁₈alkyl, C₂-C₆alkenyl, phenylvinyl, C₁-C₈alkyl which is mono- or poly-substituted by phenyl, C₂-C₅alkoxycarbonyl, halogen, C₁-C₁₂alkoxy, phenoxy, C₁-C₁₂alkylthio or/and phenylthio, C₆-C₁₂aryl which is unsubstituted or mono- or poly-substituted by C₁-C₁₂alkyl, C₁-C₁₂alkoxy, C₁-C₁₂alkoxyalkyl, C₁-C₄alkylthio or/and halogen, and R₄ is C₁-C₁₈alkyl, phenyl-C₁-C₄alkyl, C₅-C₈cycloalkyl or C₆-C₁₀aryl with the proviso that at least one of the radicals R₁, R₂ and R₃ is a substituted alkyl radical.

2. A composition according to claim 1, in which R₁ is C₁-C₁₈alkyl, C₁-C₄alkyl which is mono- to tri-substituted by phenyl, (C₁-C₄alkyl)-phenyl, chlorophenyl, (C₁-C₄alkoxy)-phenyl or/and C₁-C₄alkoxy, cyclohexyl, C₆-C₁₀aryl which is unsubstituted or mono- to tri-substituted by chlorine, C₁-C₁₂alkyl or/and C₁-C₄alkoxy, R₂ is as defined for R₁ or a radical -CO-R₃ or -OR₄, R₃ is C₁-C₈alkyl, C₁-C₆alkyl which is mono- or di-substituted by phenyl, C₁-C₄alkoxy, C₂-C₅alkoxycarbonyl or/and chlorine, or C₆-C₁₀aryl which is unsubstituted or mono- to tri-substituted by C₁-C₁₂alkyl, C₁-C₄alkoxy or/and chlorine, and R₄ is C₁-C₈alkyl, cyclohexyl, benzyl or phenyl.

3. A composition according to claim 1, in which R₁ is C₁-C₈alkyl, C₁-C₄alkyl which is mono- or di-substituted by phenyl (C₁-C₄alkyl)-phenyl or C₁-C₄alkoxy, cyclohexyl or phenyl which is unsubstituted or mono- to tri-substituted by C₁-C₄alkyl or C₁-C₄alkoxy, R₂ is as defined for R₁ or is a radical -CO-R₃ or -OR₄, R₃ is C₁-C₆alkyl which is unsubstituted or substituted by phenyl, chlorine or/and C₁-C₄alkoxy, or phenyl which is unsubstituted or mono- to tri-substituted by C₁-C₄alkyl, C₁-C₄alkoxy or/and chlorine, and R₄ is C₁-C₄alkyl, cyclohexyl or phenyl.

4. A composition according to claim 1, in which R₁ is a substituted alkyl radical as defined in claim 1.

5. A composition according to claim 4, in which R₁ is C₁-C₄alkyl which is substituted by phenyl, (C₁-C₄alkyl)-phenyl, chlorophenyl, C₁-C₄alkoxy or cyano.

6. A composition according to claim 1 of the formula I, in which R₁ is benzyl.

7. A composition according to claim 1 of the formula I, in which R₂ is C₁-C₄alkyl which is unsubstituted or substituted by phenyl, (C₁-C₄alkyl)-phenyl, chlorophenyl, C₁-C₄alkoxy or cyano, or is phenyl or cycloalkyl.

8. A composition according to claim 1 of the formula I, in which R₃ is phenyl which is substituted by C₁-C₄alkyl, C₁-C₄alkoxy or chlorine.

9. A composition according to claim 1 of the formula I, in which R₃ is C₁-C₈alkyl which is mono- to tri-substituted by phenyl, C₂-C₅alkoxycarbonyl, halogen or/and C₁-C₁₂alkoxy.

10. A composition according to claim 1, in which in the formula I R₂ is a radical -CO-R₃.

11. A composition according to claim 1, in which in the formula I R₁ is C₁-C₄alkyl which is unsubstituted or substituted by phenyl, C₁-C₄alkoxy or chlorine, phenyl or (C₁-C₄alkyl)-phenyl, R₂ is as defined for R₁ or is -O-(C₁-C₄alkyl) and R₃ is phenyl which is unsubstituted or substituted by C₁-C₄alkyl, C₁-C₄alkoxy or/and chlorine, C₁-C₄alkyl which is unsubstituted or substituted by chlorine, C₁-C₄alkoxy or phenyl.

12. A composition according to claim 1, in which in the formula I R₁ is C₁-C₄alkyl substituted by phenyl or C₁-C₄alkoxy, or phenyl, R₂ is as defined for R₁ or is -O-(C₁-C₄alkyl) and R₃ is phenyl substituted by C₁-C₄alkyl or C₁-C₄alkoxy, C₁-C₄alkyl substituted by chlorine.

13. A composition according to claim 1, which contains, in addition to the photoinitiator (b) also another photoinitiator and/or other additives.

14. A composition according to claim 1, containing 0.05 to 15 % by weight of component (b), relative to the composition.

15. A composition according to claim 1, containing 0.2 to 5 % by weight of component (b), relative to the composition.

16. The use of compounds defined in claim 1 as photoinitiators for the photopolymerization of ethyleneically unsaturated compounds.

17. The use according to claim 16 in combination with another photoinitiator and/or other additives.

18. A composition according to claim 1, which contains at least one further photoinitiator.

19. A process for photopolymerizing non-volatile monomeric, oligomeric or polymeric compounds having at least one ethylenically unsaturated double bond, which comprises adding a compound of the formula I according to claim 1 to the said compounds and irradiating with light in the range from 200 to 600 nm.

20. A process for the preparation of compounds of the formula I 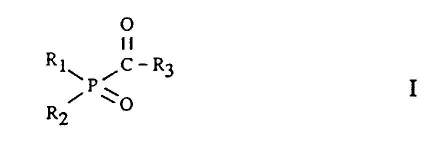 in which R₁ is C₁-C₁₈alkenyl, C₁-C₈alkyl which is monosubstituted or polysubstituted by phenyl, (C₁-C₁₂alkyl)-phenyl, halogenophenyl, (C₁-C₁₂alkoxy)-phenyl, cyano, C₂-C₅alkoxycarbonyl, C₁-C₁₂alkoxy or/and halogen, C₅-C₈cycloalkyl, C₆-C₁₂aryl which is unsubstituted or mono- or poly-substituted by halogen, C₁-C₁₂alkyl or/and C₁-C₁₂alkoxy, or is a radical of the formula 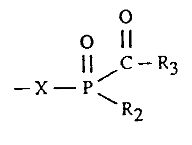 in which X is xylylene, cyclohexylene, C₁-C₆alkylene or phenylene which is unsubstituted or monosubstituted or polysubstituted by halogen, C₁-C₄alkyl, C₁-C₄alkoxy or phenyl, R₂ is C₁-C₁₈alkyl, C₂-C₁₈alkenyl, C₁-C₈alkyl which is monosubstituted or polysubstituted by phenyl, (C₁-C₁₂alkyl)-phenyl, halogenophenyl, (C₁-C₁₂alkoxy)-phenyl, cyano, C₂-C₅alkoxycarbonyl, C₁-C₁₂alkoxy or/and halogen, C₅-C₈cycloalkyl, C₆-C₁₂aryl which is unsubstituted or mono- or poly-substituted by halogen, C₁-C₁₂alkyl or/and C₁-C₁₂alkoxy, or is a radical -CO-R₃ or -OR₄, R₃ is C₁-C₁₈alkyl, C₂-C₆alkenyl, phenylvinyl, C₁-C₈alkyl which is mono- or poly-substituted by phenyl, C₂-C₅alkoxycarbonyl, halogen, C₁-C₁₂alkoxy, phenoxy, C₁-C₁₂alkylthio or/and phenylthio, C₆-C₁₂aryl which is unsubstituted or mono- or poly-substituted by C₁-C₁₂alkyl, C₁-C₁₂alkoxy, C₁-C₁₂alkoxyalkyl, C₁-C₄alkylthio or/and halogen, and R₄ is C₁-C₁₈alkyl, phenyl-C₁-C₄alkyl, C₅-C₈cycloalkyl or C₆-C₁₀aryl with the proviso that at least one of the radicals R₁, R₂ and R₃ is a substituted alkyl radical or that R₃ is a substituted cycloalkyl radical which, however, cannot contain alkyl radicals as the only substituents, which comprises reacting primary or secondary phosphines of the formula IIa or IIb
R₁ - PH₂ (IIa), 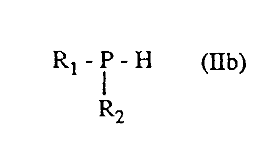
or phosphonites of the formula IIIa or IIIb 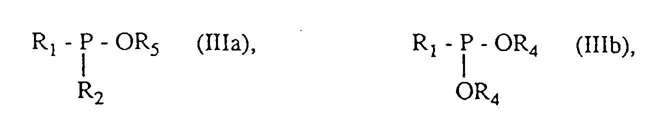 in which R₁, R₂ and R₄ are as defined above and R₅ is a C₁-C₂₀alkyl, with an acid chloride of the formula IV 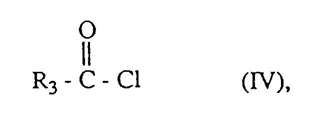 in which R₃ is as defined above, and, where compounds of the formula IIa or IIb are used as starting materials, subsequently oxidizing the acylation product.

21. A process according to claim 20, wherein the acylation is carried out in the presence of a base.

## Revendications (Revendications pour l'(les) Etat(s) contractant(s) suivant(s): BE, CH, DE, FR, GB, IT, LI, NL)

1. Composé de formule I : 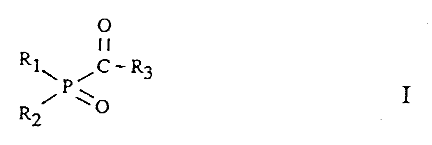 dans laquelle R₁ est un radical alkyle en C₁-C₁₈, alcényle en C₂-C₁₈, aryle en C₆-C₁₂, cycloalkyle en C₅-C₈ ou alkyle en C₁-C₈, une ou plusieurs fois substitués par des substituants phényle, (alkyle en C₁-C₁₂)-phényle, halogénophényle, (alcoxy en C₁-C₁₂)-phényle, cyano, (alcoxy en C₂-C₅)carbonyle, alcoxy en C₁-C₁₂ et/ou halogéno, aryle en C₆-C₁₂ une ou plusieurs fois substitué par des substituants halogéno, alkyle en C₁-C₁₂ et/ou alcoxy en C₁-C₁₂, ou encore un radical de formule : 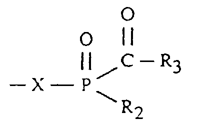 dans laquelle X est un radical alkylène en C₁-C₆, cyclohexylène, xylylène ou phénylène non substitué ou une ou plusieurs fois substitué par des substituants halogéno, alkyle en C₁-C₄, alcoxy en C₁-C₄ ou phényle,
dans laquelle R₂ est un radical alkyle en C₁-C₁₈, alcényle en C₂-C₁₈, ou aryle en C₆-C₁₂, cycloalkyle en C₅-C₈ ou alkyle en C₁-C₈ une ou plusieurs fois substitués par des substituants phényle, (alkyle en C₁-C₁₂)-phényle, halogénophényle, (alcoxy en C₁-C₁₂)-phényle, cyano, (alcoxy en C₂-C₅)carbonyle, alcoxy en C₁-C₁₂ et/ou halogéno, aryle en C₆-C₁₂ une ou plusieurs fois substitué par des substituants halogéno, alkyle en C₁-C₁₂ et/ou alcoxy en C₁-C₁₂, ou encore un radical -CO-R₃ ou -OR₄,
R₃ est un radical alkyle en C₁-C₁₈, alcényle en C₂-C₆, phénylvinyle, ou encore alkyle en C₁-C₈ une ou plusieurs fois substitué par des substituants phényle, (alcoxy en C₂-C₅)carbonyle, halogéno, alcoxy en C₁-C₁₂, phénoxy, alkylthio en C₁-C₁₂ et/ou phénylthio, un radical aryle en C₆-C₁₂ non substitué ou une ou plusieurs fois substitué par des substituants alkyle en C₁-C₁₂, alcoxy en C₁-C₁₂, alcoxyalkyle en C₁-C₁₂, alkylthio en C₁-C₄ et/ou halogéno, et
R₄ est un radical alkyle en C₁-C₁₈, phényl-(alkyle en C₁-C₄), cycloalkyle en C₅-C₈ ou aryle en C₆-C₁₀, à la condition qu'au moins l'un des radicaux R₁, R₂ et R₃ soit un radical alkyle substitué.

2. Composé selon la revendication 1 de formule I, dans laquelle :
R₁ est un radical alkyle en C₁-C₁₂, ou aryle en C₁-C₁₀, cyclohexyle ou alkyle en C₁-C₄ une à trois fois substitué par des substituants phényle, (alkyle en C₁-C₄)-phényle, chlorophényle, (alcoxy en C₁-C₄)-phényle et/ou alcoxy en C₁-C₄, ou encore aryle en C₆-C₁₀ une à trois fois substitué par des substituants chloro, alkyle en C₁-C₁₂ et/ou alcoxy en C₁-C₄,
R₂ a l'une des significations données pour R₁ ou représente un radical -CO-R₃ ou -OR₄,
R₃ est un radical alkyle en C₁-C₈, alkyle en C₁-C₆ une ou deux fois substitué par des substituants phényle, alcoxy en C₁-C₄, (alcoxy en C₂-C₅)carbonyle et/ou chloro, aryle en C₆-C₁₀, ou aryle en C₆-C₁₀, une à trois fois substitué par des substituants alkyle en C₁-C₁₂, alcoxy en C₁-C₄ et/ou chloro, et R₄ est un groupe alkyle en C₁-C₈, cyclohexyle, benzyle ou phényle.

3. Composé selon la revendication 1 de formule I, dans laquelle :
R₁ est un radical alkyle en C₁-C₈, alkyle en C₁-C₄ une ou deux fois substitué par des substituants phényle, (alkyle en C₁-C₄)phényle ou alcoxy en C₁-C₄, cyclohexyle, phényle ou encore phényle une à trois substitué par des substituants alkyle en C₁-C₄ ou alcoxy en C₁-C₄,
R₂ a l'une des significations données pour R₁ ou représente un radical -CO-R₃ ou -OR₄,
R₃ est un groupe alkyle en C₁-C₆ non substitué ou substitué par des substituants phényle, chloro et/ou alcoxy en C₁-C₄, phényle, ou phényle une à trois substi-tué par des substituants alkyle en C₁-C₄, alcoxy en C₁-C₄ et/ou chloro, et
R₄ est un groupe alkyle en C₁-C₄, cyclohexyle ou phényle.

4. Composé selon la revendication 1 de formule I, dans lequel R₁ est un résidu alkyle substitué comme défini dans la revendication 1.

5. Composé selon la revendication 4, dans lequel R₁ est un radical alkyle en C₁-C₄ substitué par des substituants phényle, (alkyle en C₁-C₄)phényle, chlorophényle, alcoxy en C₁-C₄ ou cyano.

6. Composé selon la revendication 1 de formule I dans lequel R₁ est le groupe benzyle.

7. Composé selon la revendication 1 de formule I, dans lequel R₂ est un radical phényle, cycloalkyle ou alkyle en C₁-C₄ non substitué ou substitué par des substituants phényle, (alkyle en C₁-C₄)-phényle, chlorophényle, alcoxy en C₁-C₄ ou cyano.

8. Composé selon la revendication 1 de formule I, dans lequel R₃ est un radical phényle substitué par des substituants alkyle en C₁-C₄, alcoxy en C₁-C₄ ou chloro.

9. Composé selon la revendication 1 de formule I, dans lequel R₃ est un groupe alkyle une à trois fois substitué par des substituants phényle, (alcoxy en C₂-C₅) carbonyle, halogéno et/ou alcoxy en C₁-C₁₂.

10. Composé selon la revendication 1 de formule I, dans lequel R₂ est un résidu -CO-R₃.

11. Composé selon la revendication 1 de formule I, dans lequel R₁ est un radical phényle, (alkyle en C₁-C₄) phényle ou alkyle en C₁-C₄ non substitué ou substitué par des substituants phényle, alcoxy en C₁-C₄ ou chloro, R₂ a les significations de R₁ ou est un radical -O-(alkyle en C₁-C₄), et R₃ est un groupe phényle non substitué ou substitué par des substituants alkyle en C₁-C₄, alcoxy en C₁-C₄ et/ou chloro, ou alkyle en C₁-C₄, non substitué ou substitué par des substituants chloro, alcoxy en C₁-C₄ ou phényle.

12. Composé selon la revendication 1 de formule I, dans lequel R₁ est un radical alkyle en C₁-C₄ ou phényle substitué par des substituants phényle ou alcoxy en C₁-C₄, R₂ a la signification de R₁ ou représente un radical -O-(alkyle en C₁-C₄), et R₃ est un radical phényle substitué par des substituants alkyle en C₁-C₄ ou alcoxy en C₁-C₄, ou alkyle en C₁-C₄ substitué par le chlore.

13. Composition photopolymérisable, contenant :
(a) au moins un composé photopolymérisable à insaturation éthylénique, et
(b) en tant que photoamorceur, au moins un composé de formule I tel que défini dans la revendication 1.

14. Composition selon la revendication 13, caractérisée en ce que, outre le photoamorceur (b), elle contient encore un autre photoamorceur et/ou d'autres additifs.

15. Composition selon la revendication 13, contenant de 0,05 à 15 % en poids du constituant (b) par rapport à la composition.

16. Composition selon la revendication 13, contenant de 0,2 à 5 % en poids du constituant (b) par rapport à la composition.

17. Utilisation de composés définis dans la revendication 1 en tant que photoamorceurs pour la photopolymérisation de composés à insaturation éthylénique.

18. Utilisation selon la revendication 17, en combinaison avec un autre photoamorceur et/ou d'autres additifs.

19. Composition selon la revendication 13, qui contient au moins un autre photoamorceur.

20. Procédé de photopolymérisation de composés monomères, oligomères ou polymères non volatils, comportant au moins une double liaison à insaturation éthylénique, caractérisé en ce qu'on ajoute aux composés ci-dessus un composé de formule I selon la revendication 1, et qu'on les expose à une lumière comprise dans l'intervalle de 200 à 600 nm.

## Revendications (Revendications pour l'(les) Etat(s) contractant(s) suivant(s): ES)

1. Composition photopolymérisable, contenant :
(a) au moins un composé photopolymérisable à insaturation éthylénique, et
(b) en tant que photoamorceur, au moins un composé de formule I : 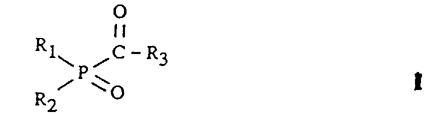 dans laquelle R₁ est un radical alkyle en C₁-C₁₈, alcényle en C₂-C₁₈, ou aryle en C₆-C₁₂, cycloalkyle en C₅-C₈ ou alkyle en C₁-C₈ une ou plusieurs fois substitués par des substituants phényle, (alkyle en C₁-C₁₂)-phényle, halogénophényle, (alcoxy en C₁-C₁₂)-phényle, cyano, (alcoxy en C₂-C₅)carbonyle, alcoxy en C₁-C₁₂ et/ou halogéno, aryle en C₆-C₁₂ une ou plusieurs fois substitué par des substituants halogéno, alkyle en C₁-C₁₂ et/ou alcoxy en C₁-C₁₂, ou encore un radical de formule : 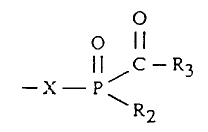 dans laquelle X est un radical alkylène en C₁-C₆, cyclohexylène, xylylène ou phénylène non substitué ou une ou plusieurs fois substitué par des substituants halogéno, alkyle en C₁-C₄, alcoxy en C₁-C₄ ou phényle,
dans laquelle R₂ est un radical alkyle en C₁-C₁₈, alcényle en C₂-C₁₈, ou aryle en C₆-C₁₂, cycloalkyle en C₅-C₈ ou alkyle en C₁-C₈ une ou plusieurs substitués par des substituants phényle, (alkyle en C₁-C₁₂)phényle, halogénophényle (alcoxy en C₁-C₁₂)-phényle, cyano, (alcoxy en C₂-C₅)carbonyle, alcoxy en C₁-C₁₂ et/ou halogéno, aryle en C₆-C₁₂ une ou plusieurs fois substitué par des substituants halogéno, alkyle en C₁-C₁₂ et/ou alcoxy en C₁-C₁₂, ou encore un radical -CO-R₃ ou -OR₄,
R₃ est un radical alkyle en C₁-C₁₈, alcényle en C₂-C₆, phénylvinyle, ou encore alkyle en C₁-C₈ une ou plusieurs fois substitué par des substituants phényle, (alcoxy en C₂-C₅)carbonyle, halogéno, alcoxy en C₁-C₁₂, phénoxy, alkylthio en C₁-C₁₂ et/ou phénylthio, un radical aryle en C₆-C₁₂ non substitué ou une ou plusieurs fois substitué par des substituants alkyle en C₁-C₁₂, alcoxy en C₁-C₁₂, alcoxyalkyle en C₁-C₁₂, alkylthio en C₁-C₄ et/ou halogéno, et
R₄ est un radical alkyle en C₁-C₁₈, phényl-(alkyle en C₁-C₄), cycloalkyle en C₅-C₈ ou aryle en C₆-C₁₀, à la condition qu'au moins l'un des radicaux R₁, R₂ et R₃ soit un radical alkyle substitué.

2. Composition selon la revendication 1, dans laquelle :
R₁ est un radical alkyle en C₁-C₁₂, ou aryle en C₁-C₁₀, cyclohexyle ou alkyle en C₁-C₄ une à trois fois substitué par des substituants phényle, (alkyle en C₁-C₄)-phényle, chlorophényle, (alcoxy en C₁-C₄)-phényle et/ou alcoxy en C₁-C₄, ou encore aryle en C₆-C₁₀ une à trois fois substitué par des substituants chloro, alkyle en C₁-C₁₂ et/ou alcoxy en C₁-C₄,
R₂ a l'une des significations données pour R₁ ou représente un radical -CO-R₃ ou -OR₄,
R₃ est un radical alkyle en C₁-C₈, alkyle en C₁-C₆ une ou deux fois substitué par des substituants phényle, alcoxy en C₁-C₄, (alcoxy en C₂-C₅)carbonyle et/ou chloro, aryle en C₆-C₁₀, ou aryle en C₆-C₁₀ une à trois substitué par des substituants alkyle en C₁-C₁₂, alcoxy en C₁-C₄ et/ou chloro, et R₄ est un groupe alkyle en C₁-C₈, cyclohexyle, benzyle ou phényle.

3. Composition selon la revendication 1, dans laquelle :
R₁ est un radical alkyle en C₁-C₈, alkyle en C₁-C₄ une ou deux fois substitué par des substituants phényle, (alkyle en C₁-C₄)phényle ou alcoxy en C₁-C₄, cyclohexyle, phényle ou encore phényle une à trois substitué par des substituants alkyle en C₁-C₄ ou alcoxy en C₁-C₄,
R₂ a l'une des significations données pour R₁ ou représente un radical -CO-R₃ ou -OR₄,
R₃ est un groupe alkyle en C₁-C₆ non substitué ou substitué par des substituants phényle, chloro et/ou alcoxy en C₁-C₄, phényle, ou phényle une à trois substi-tué par des substituants alkyle en C₁-C₄, alcoxy en C₁-C₄ et/ou chloro, et
R₄ est un groupe alkyle en C₁-C₄, cyclohexyle ou phényle.

4. Composition selon la revendication 1 de formule I, dans laquelle R₁ est un résidu alkyle substitué comme défini dans la revendication 1.

5. Composition selon la revendication 4, dans laquelle R₁ est un radical alkyle en C₁-C₄ substitué par des substituants phényle, (alkyle en C₁-C₄)phényle, chlorophényle, alcoxy en C₁-C₄ ou cyano.

6. Composition selon la revendication 1 de formule I dans laquelle R₁ est le groupe benzyle.

7. Composition selon la revendication 1 de formule I, dans laquelle R₂ est un radical phényle, cycloalkyle ou alkyle en C₁-C₄ non substitué ou substitué par des substituants phényle, (alkyle en C₁-C₄)-phényle, chlorophényle, alcoxy en C₁-C₄ ou cyano.

8. Composition selon la revendication 1 de formule I, dans laquelle R₃ est un radical phényle substitué par des substituants alkyle en C₁-C₄, alcoxy en C₁-C₄ ou chloro.

9. Composition selon la revendication 1 de formule I, dans laquelle R₃ est un groupe alkyle en C₁-C₈ une à trois fois substitué par des substituants phényle (alcoxy en C₂-C₅) carbonyle, halogéno et/ou alcoxy en C₁-C₁₂.

10. Composition selon la revendication 1 de formule I, dans laquelle R₂ est un résidu -CO-R₃.

11. Composition selon la revendication 1 de formule I, dans laquelle R₁ est un radical phényle, (alkyle en C₁-C₄) phényle ou alkyle en C₁-C₄ non substitué ou substitué par des substituants phényle, alcoxy en C₁-C₄ ou chloro, R₂ a la signification de R₁ ou est un radical -O-(alkyle en C₁-C₄), et R₃ est un groupe phényle non substitué ou substitué par des substituants alkyle en C₁-C₄, alcoxy en C₁-C₄ et/ou chloro, ou alkyle en C₁-C₄, non substitué ou substitué par des substituants chloro, alcoxy en C₁-C₄ ou phényle.

12. Composition selon la revendication 1 de formule I, dans laquelle R₁ est un radical alkyle en C₁-C₄ ou phényle substitué par des substituants phényle ou alcoxy en C₁-C₄, R₂ a les significations de R₁ ou représente un radical -O-(alkyle en C₁-C₄), et R₃ est un radical phényle substitué par des substituants alkyle en C₁-C₄ ou alcoxy en C₁-C₄, ou alkyle en C₁-C₄ substitué par le chlore.

13. Composition selon la revendication 1, caractérisée en ce que, outre le photoamorceur (b), elle contient encore un autre photoamorceur et/ou d'autres additifs.

14. Composition selon la revendication 1, contenant de 0,05 à 15 % en poids du constituant (b) par rapport à la composition.

15. Composition selon la revendication 1, contenant de 0,2 à 5 % en poids du constituant (b) par rapport à la composition.

16. Utilisation de composés définis dans la revendication 1 en tant que photoamorceurs pour la photopolymérisation de composés à insaturation éthylénique.

17. Utilisation selon la revendication 16, en combinaison avec un autre photoamorceur et/ou d'autres additifs.

18. Composition selon la revendication 1, qui contient au moins un autre photoamorceur.

19. Procédé de photopolymérisation de composés monomères, oligomères ou polymères non volatils, comportant au moins une double liaison à insaturation éthylénique, caractérisé en ce qu'on ajoute aux composés ci-dessus un composé de formule I selon la revendication 1, et qu'on les expose à une lumière comprise dans l'intervalle de 200 à 600 nm.

20. Procédé pour préparer des composés de formule I, 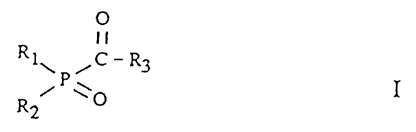 dans laquelle R₁ est un radical alkyle en C₁-C₁₈, alcényle en C₂-C₁₈, ou aryle en C₆-C₁₂, cycloalkyle en C₅-C₈ ou alkyle en C₁-C₈ une ou plusieurs substitués par des substituants phényle, (alkyle en C₁-C₁₂)phényle, halogénophényle (alcoxy en C₁-C₁₂)-phényle, cyano, (alcoxy en C₂-C₅)carbonyle, alcoxy en C₁-C₁₂ et/ou halogéno, aryle en C₆-C₁₂ une ou plusieurs fois substitué par des substituants halogéno, alkyle en C₁-C₁₂ et/ou alcoxy en C₁-C₁₂, ou encore un radical de formule : 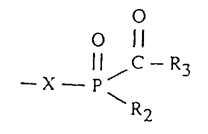 dans laquelle X est un radical alkylène en C₁-C₆, cyclohexylène, xylylène ou phénylène non substitué ou une ou plusieurs fois substitué par des substituants halogéno, alkyle en C₁-C₄, alcoxy en C₁-C₄ ou phényle,
dans laquelle R₂ est un radical alkyle en C₁-C₁₈, alcényle en C₂-C₁₈, ou aryle en C₆-C₁₂, cycloalkyle en C₅-C₈ ou alkyle en C₁-C₈ une ou plusieurs substitués par des substituants phényle, (alkyle en C₁-C₁₂)phényle, halogénophényle (alcoxy en C₁-C₁₂)-phényle, cyano, (alcoxy en C₂-C₅)carbonyle, alcoxy en C₁-C₁₂ et/ou halogéno, aryle en C₆-C₁₂ une ou plusieurs fois substi-tué par des substituants halogéno, alkyle en C₁-C₁₂ et/ou alcoxy en C₁-C₁₂, ou encore un radical -CO-R₃ ou -OR₄,
R₃ est un radical alkyle en C₁-C₁₈, alcényle en C₂-C₆, phénylvinyle, ou encore alkyle en C₁-C₈ une ou plusieurs fois substitué par des substituants phényle, (alcoxy en C₂-C₅)carbonyle, halogéno, alcoxy en C₁-C₁₂, phénoxy, alkylthio en C₁-C₁₂ et/ou phénylthio, un radical aryle en C₆-C₁₂ non substitué ou une ou plusieurs fois substitué par des substituants alkyle en C₁-C₁₂, alcoxy en C₁-C₁₂, alcoxyalkyle en C₁-C₁₂, alkylthio en C₁-C₄ et/ou halogéno, et
R₄ est un radical alkyle en C₁-C₁₈, phényl-(alkyle en C₁-C₄), cycloalkyle en C₅-C₈ ou aryle en C₆-C₁₀, à la condition qu'au moins l'un des radicaux R₁, R₂ et R₃ soit un radical alkyle substitué,
ou que R₃ soit un radical cycloalkyle substitué, qui cependant peut contenir des radicaux alkyle en tant que substituants non uniques, caractérisé en ce qu'on fait réagir des phosphines primaires ou secondaires de formule IIa ou IIb,
R₁ - PH₂ (IIa), 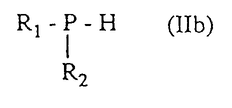
ou des phosphonites de formule IIIa ou IIIb 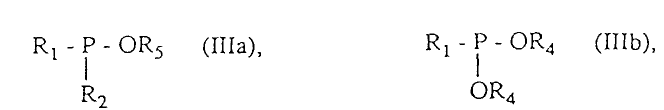 où R₁, R₂ et R₄ ont les significations données ci-dessus, et R₅ est un groupe alkyle en C₁-C₂₀,
avec un chlorure d'acyle de formule IV : 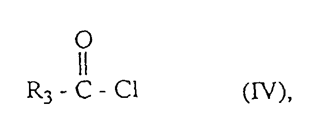 où R₃ a les significations données ci-dessus, puis, dans le cas dans lequel on utilise des composés de formule IIa ou IIb en tant que produits, on oxyde le produit d'acylation.

21. Procédé selon la revendication 20, dans lequel l'acylation est mise en oeuvre en présence d'une base.
